(19) Europäisches Patentamt
European Patent Office
Office européen des brevets

(11) **EP 2 143 832 A2**

(12) # EUROPEAN PATENT APPLICATION

(43) Date of publication:
**13.01.2010 Bulletin 2010/02**

(51) Int Cl.:
***C30B 25/02*** (2006.01)  ***C30B 29/40*** (2006.01)

(21) Application number: **09165060.6**

(22) Date of filing: **09.07.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **11.07.2008 US 171623**

(71) Applicant: **Palo Alto Research Center Incorporated**
**Palo Alto, California 94304 (US)**

(72) Inventors:
• **Bour, David P.**
**Cupertino, CA 95014 (US)**
• **Kiesel, Peter**
**Palo Alto, CA 94306 (US)**

• **Chua, Christopher L.**
**San Jose, CA 95123 (US)**
• **Johnson, Noble M.**
**Menlo Park, CA 94025 (US)**
• **Yang, Zhihong**
**Sunnyvale, CA 94086 (US)**
• **Northrup, John E.**
**Palo Alto, CA 94304 (US)**

(74) Representative: **Grünecker, Kinkeldey, Stockmair & Schwanhäusser**
**Anwaltssozietät**
**Leopoldstrasse 4**
**80802 München (DE)**

(54) **Method and reactor for preparing films and devices under high nitrogen chemical potential**

(57)    Nitride semiconductor films, such as for use in solid state light emitting devices and electronic devices, are fabricated in an environment of relatively high nitrogen potential such that nitrogen vacancies in the growing film are reduced. A reactor design, and method for its use, provide high nitrogen precursor partial pressure, precracking of the precursor using a catalytic metal surface, prepyrolyzing the precursor, using catalytically-cracked molecular nitrogen as a nitrogen precursor, and/or exposing the surface to an ambient which is extremely rich in active nitrogen species. Improved efficiency for light emitting devices, particularly in the blue and green wavelengths and improve transport properties in nitride electronic devices, i.e., improved performance from nitride-based devices such as InGaAlN laser diodes, transistors, and light emitting diodes is thereby provided.

FIG. 8

EP 2 143 832 A2

## Description

## BACKGROUND

The present invention is related to semiconductor devices and methods of producing same, and more specifically to epitaxial nitride semiconductor films, heterostructures, and devices, and methods of producing same under conditions of high nitrogen chemical potential.

Nitride semiconductor light-emitting diodes (LEDs), laser diodes (LDs) and electronic devices are typically formed in a metalorganic chemical vapor deposition (MOCVD) epitaxial growth process. For aluminum-gallium-indium-nitride (AlGaInN) quantum well (QW) LEDs and LDs, the AlGaInN quantum well active region and pn junction comprise the critical portion of the device. Ideal crystalline films for these nitride devices have neither extended defects (e.g., dislocations arising from lattice mismatch or phase boundaries), nor point defects (e.g., impurities, vacancies, interstitials, etc.) It is these defects that prevent light-emitting devices from providing internal quantum efficiency approaching 100% (unity), that is, each recombination producing a desired photon. In arsenide and phosphide semiconductor light-emitters, internal quantum efficiency of unity is often realized. But not so with nitride devices.

For nitride devices, defects are present in the epitaxial films, degrading the performance of the devices fabricated therefrom. For such films often contain dislocations (extended nonradiative defects) which degrade the internal quantum efficiency of LEDs and LDs, and reduce the mobility and breakdown voltage in electronic devices incorporating nitride films. Likewise, point defects are often present, especially vacancies and some impurities, which create mid-gap energy states responsible for rapid nonradiative recombination. Such point defects are commonly formed during growth, depending on the purity of the growth environment, the epitaxial growth conditions, and the solid-state chemistry associated with their formation.

One reason that such defects appear in nitride-based devices is that to obtain longer wavelength optical output a nitride film is employed and the indium content of the active layer is increased. However, as the indium content increases, defects are introduced and the group-V element (nitrogen) is displaced. Accordingly, the internal quantum efficiency of these devices, such as gallium nitride (GaN) based laser diodes and light-emitting diodes, and in particular indium gallium nitride (InGaN) devices, is relatively poor. This is particularly true for devices such as green LEDs which incorporate relatively high indium-content InGaN alloy active regions.

In general for compound- and elemental-semiconductors, the defect concentration is influenced by the epitaxial growth conditions (growth rate, temperature, V:III ratio, pressure, etc.) For example, for GaN-based LEDs and LDs, high growth pressure has been employed to produce emitters with higher quantum efficiency, a benefit ascribed to superior structural quality (i.e., fewer extended defects). Likewise, the optical efficiency of arsenide and phosphide light-emitting devices may be greatly improved by flowing greater quantities of the group-V-hydride (V-H$_3$) precursor. In this case, the high V-H$_3$ flow suppresses the formation of group-V vacancies, which represent nonradiative point defects.

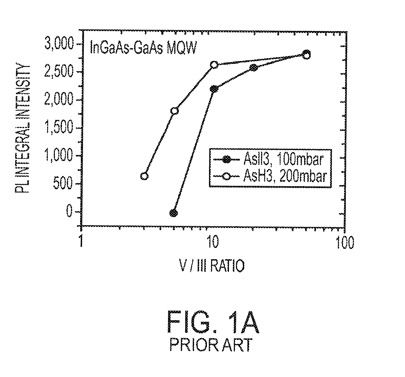

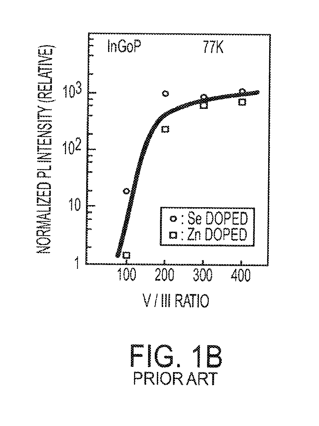

It is well-established for arsenide and phosphide (near-infrared and red) LDs and LEDs that the MOCVD epitaxial growth process requires some minimum value of the group-V hydride precursor flow, arsine (AsH$_3$) or phosphine (PH$_3$), to produce material of high optoelectronic quality (internal quantum efficiency approaching unity). This is shown in Figs. 1A and 1B, which are a plots of the photoluminescence efficiency of arsenide (InGaAs-GaAs, Fig. 1A) and phosphide (bulk InGaP, Fig. 1B) semiconductors as a function of the group-V to group-III molar ratio (V:III ratio) employed during epitaxial growth. Furthermore, the poor efficiency of material grown at low a low V:III ratio has been determined to be a consequence of a high group-V vacancy concentration. Therefore, there is some minimum value for the group-V hydride precursor flow required to suppress formation of these vacancies.

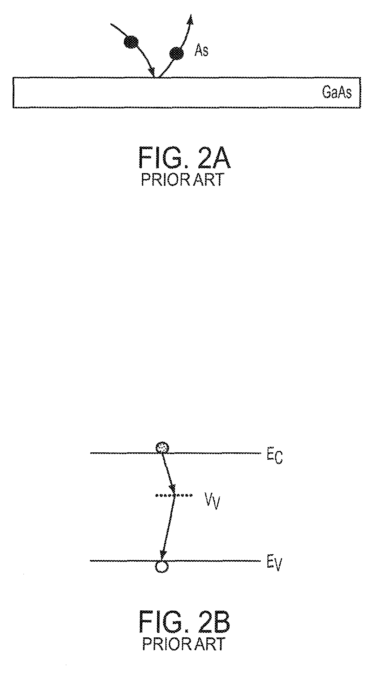

A microscopic picture of the interaction between the hot, growing crystal surface and the gaseous growth ambient is shown in Fig. 2A. Group-V atoms are continually escaping from the surface, but are replaced from the growth ambient, which includes the group-V precursor. Typical growth temperatures for III-V epitaxy are well above the congruent sublimation point for the material. However, if the escape rate exceeds the replacement rate (i.e., the vapor pressure (evaporation rate) of the group-V species (e.g., As, P, N) is greater than the rate at which group V species are supplied from the vapor precursors), vacancies are formed. The consequence of these vacancies are non-radiative transitions, shown in Fig. 2B, which decrease optical efficiency of the film. The evaporation rate can exceed the replacement rate when, for example, there is an insufficient group V supply. Thus, as indicated in Figs. 1A and 1B, material grown at low VH$_3$ flows may be optically inefficient.

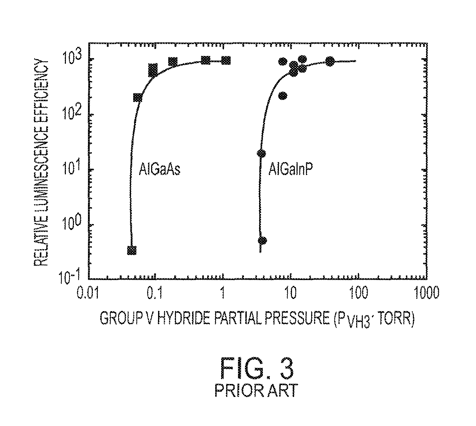

For a given set of growth conditions, the group-V vacancy (V$_v$) concentration is governed by the solid-state chemistry and energetics associated with its formation, combined with the flux of active group-V species delivered from the ambient. To some extent, this flux depends on reactor design/geometry in addition to the V-H$_3$ and carrier-gas flows, since the reactor geometry may affect the chemical activity of the V-H$_3$ precursor through upstream heating or in some cases catalytic precracking. Nevertheless, it is recognized that it is the group-V flux which is the important parameter in the group-V vacancy formation mechanism, and not simply the V:III ratio that is most often quoted. Accordingly, it is preferred to consider the vacancy formation in terms of the group-V partial pressure during growth, rather than the V:III ratio. In order to visualize this, the data from Fig. 1A and Fig. 1B are replotted together in Fig. 3 as function of group-V partial pressure rather than V:III ratio.

Note that in Fig. 3 the two arsenide characteristics from Fig. 1A (curves corresponding to variations in $AsH_3$ flow, for two total pressures) collapse into a single characteristic when replotted in terms of partial pressure. This supports the hypothesis that the group-V partial pressure and not V:III is the critical parameter, independently and universally governing the group-V vacancy formation. It can be concluded from this that there is some critical partial pressure of group-V precursor species that is required to make $V_v$ acceptably small (although this value is reactor dependent, through its impact on chemical activity of the group-V hydride precursor). Moreover, the phosphine partial pressure required to grow efficient phosphides is one- to two-orders of magnitude higher than for arsenides. This is so because phosphine is a more strongly bound molecule which is less efficiently pyrolyzed during the MOCVD process.

Fig. 3 indicates that for a given group-V precursor flow, more efficient material is obtained for a higher total pressure, because this equates to a higher group-V partial pressure (higher group V chemical potential). Equivalently, for a high growth pressure, a lower group-V precursor flow is required for realizing efficient material. However, for nitride semiconductors, this relationship between growth conditions and optical efficiency is not so well established. In part, this is due to the very complicated nature of optical recombination processes in nitride semiconductors, involving alloy inhomogeneity, spontaneous- and piezoelectric-polarization fields, and extended defects. Nevertheless, there exist several examples where high (total) growth pressures have led to improved performance of nitride devices.

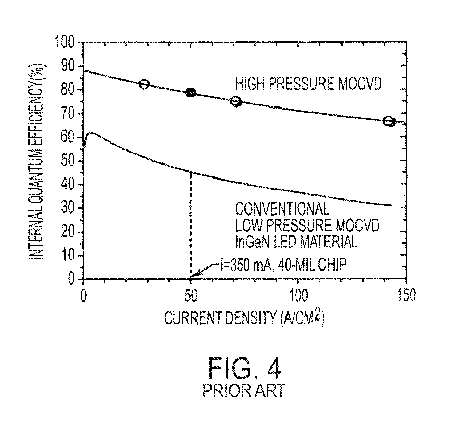

Fig. 4 illustrates the internal quantum efficiency (IQE) versus drive current density for a current "blue" LED with a very high IQE. At low current, the IQE approaches a nearly ideal value of 90%, falling off at higher current due to either Auger recombination or delocalization of injected carriers. At a typical operating current density of 50 A/cm$^2$ (corresponding to 350 mA through a 1 mm x 1 mm chip), the IQE of this device is approximately 80%, compared to about 50% for most other commercial LEDs. While it is known that this device is produced in a reactor at atmospheric pressure (relatively much higher than typical MOVCD reactors today), the details of the reactor design are proprietary to the manufacturer, Nichia Corporation (Tokushima, Japan, www.nichia.com). Furthermore, additional growth parameters for the device whose data is shown in Fig. 4 do not appear to be currently publicly available. Commercial MOCVD reactors on the market today are limited to either low-pressure operation, or operate at elevated-pressure conditions where the group-V precursor is highly diluted by additional carrier gas.

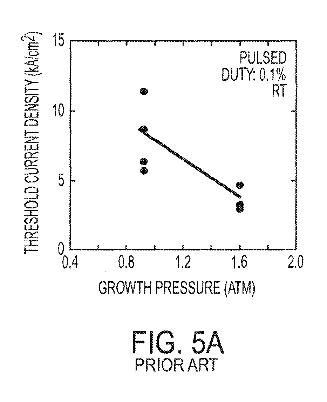

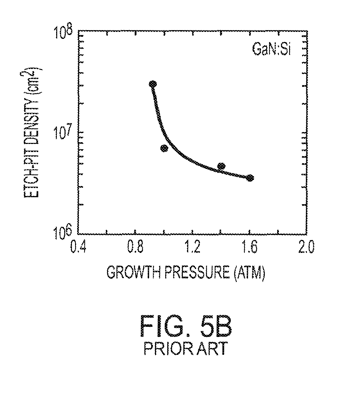

It is also known that higher total growth pressure leads to lower threshold laser diodes. This is illustrated in Figs. 5A and 5B for near-UV, 405 nm LDs, for which threshold current density is plotted as a function of the MOCVD reactor growth pressure used for deposition of AlGaInN multiple-QW LDs. It is seen that the threshold current is lower for a high growth pressure. This improvement has been ascribed to the superior structural quality (lower threading dislocation density) resulting from high-pressure MOCVD of GaN, as indicated by Fig. 5B. However, although the improved laser performance is correlated with high-pressure growth, it has not been shown to be correlated with the lower defect density. This suggests that the benefit of high pressure MOCVD accrues from some mechanism other than reduced defect density.

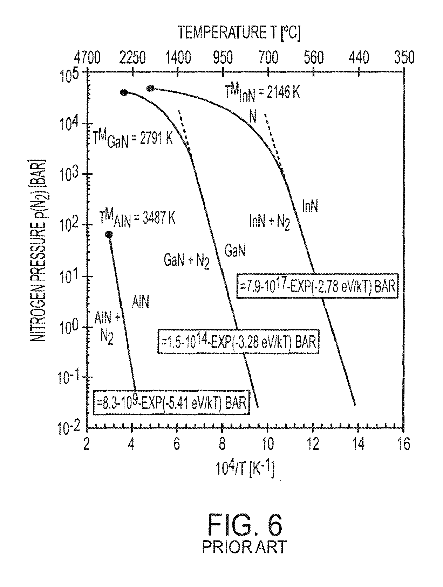

Finally, for green LEDs, the indium content of the InGaN quantum well (QW) is necessarily much higher than for shorter-wavelength emitters. High-indium-content alloys are more prone to nitrogen-vacancy formation, due to their inherent thermal instability. (The In-N bond strength is reduced in comparison to the Ga-N bond strength.) This is illustrated in Fig. 6, which is a graph of the equilibrium nitrogen pressure over the binary nitride semiconductors AlN, GaN, and InN. The $N_2$ pressure over InN is 4-5 orders of magnitude greater than for GaN. This implies that high-indium content alloys evolve nitrogen more readily, leading to a greater propensity for nitrogen vacancy formation (or in extreme cases decomposition). Moreover, these high-In alloys must also be grown at a relatively low temperature, in order to suppress evaporation of indium from the surface. Although the nitrogen evolution rate falls with the temperature, the pyrolysis rate of the ammonia also decreases. Thus, high-indium-content alloys appear to suffer from a greater tendency to form nitrogen vacancies. This interpretation is consistent with the relatively poor performance of green (high-indium-content) emitters. However, we also note that this is counter to the traditional explanations which involve high piezoelectric field, alloy inhomogeneity, and possibly strain-related structural defect formation.

While the mechanism(s) underlying the improved optoelectronic quality are currently not definitively understood, these examples illustrate the possible benefit of film growth in the presence of high nitrogen partial pressure. There is currently a need in the art for improved efficiency for light emitting devices, particularly in the blue and green wavelengths, i.e., improved efficiency from nitride-based devices such as GaN LDs and LEDs.

## SUMMARY

Accordingly, the present disclosure is directed to methods for providing nitride semiconductors, and the resulting structures, having a reduced non-radiative vacancy defect density. This low defect density is achieved through epitaxial growth under the proper conditions, specifically a high group V chemical potential (i.e., group V element readily incorporated into the growth surface to fill vacancies), for example a high partial pressure of active nitrogen species.

From the analysis of luminescence efficiency and current density for arsenides and phosphides, we have determined that group V potential (e.g., higher reactor pressure) leads to a desirable increase in device performance. Specifically, extrapolating these characteristics to the nitrides, nitride semiconductors also demonstrate an increase in efficiency when formed in a high group V potential environment, for example in a high-pressure reactor.

We understand the mechanism for the pressure-related improvement in device performance to be a result of the higher group-V precursor partial pressure. That is, the devices are formed in the presence of a higher concentration of arsenic or phosphorous. The high concentration of the group-V precursor results in fewer non-radiative defects, specifically minimizing the tendency for arsenic or phosphorous vacancy formation. Similarly, by forming nitride-based devices in a high partial pressure of the nitrogen precursor, for example ammonia ($NH_3$), the nitrogen vacancy defects are reduced. Accordingly, growth conditions which correspond to a high N chemical potential are favorable for producing nitrides of excellent optoelectronic quality. However, as $NH_3$ is a "stronger" molecule than $PH_3$ (i.e., it requires a greater amount of energy to dissociate to its elemental constituents) a higher ammonia partial pressure is required as compared to the required partial pressure of $PH_3$. Appropriate partial pressures for nitride device formation will vary, but may be as high as 400 torr or even exceed one atmosphere in certain embodiments.

It should be noted that $NH_3$ is just one of a class of nitrogen precursors which may serve as a source of the group-V atoms. Other such precursors include hydrazine ($H_4N_2$), dimethylhydrazine ($C_2H_8N_2$), etc.

Therefore, according to one aspect of the present disclosure, a method of forming a nitride semiconductor device includes the steps of pressurizing the reactor in which the device is formed with a relatively high partial pressure of the group-V precursor, and forming the device in the presence of that high pressure precursor. A relatively high population of a group-V atom is thereby provided for incorporation into the growth surface. According to one embodiment, the group-V element is nitrogen and the precursor is $NH_3$.

In one embodiment of the method of claim 9, said at least one heated channel has a catalytic surface, and further wherein said predissociation comprises injecting said precursor gas over said heated, catalytic channel surface in order to reduce the energy necessary to produce reactive nitrogen from said precursor gas and provide said reactive nitrogen at a relative high chemical potential for incorporation into the growth surface of said growth substrate.

In a further embodiment said precursor gas is pre-treated prior to being injected through at least one heated channel in order to reduce the energy necessary to produce reactive nitrogen therefrom and provide said reactive nitrogen at a relative high chemical potential for incorporation into the growth surface of said growth substrate. In a further embodiment said pre-treating comprises pre-cracking said precursor gas.

Another aspect of the present disclosure is a method by which a first precursor is, through pyrolisys or catalytic reaction, predissociated or converted into a second precursor of a type which requires less energy to render atomic nitrogen. The steps of, and novel device for, realizing this method is disclosed herein.

An alternate aspect may be embodied in a method by which a device layer is formed by processes well known in the art, then exposed to an environment rich in elemental nitrogen. Elemental nitrogen is then incorporated into the as-grown layer to fill nitrogen vacancies therein. A next layer is then grown by the well-known process, and that layer in turn exposed to a nitrogen rich environment. This growth-exposure sequence may be repeated several to many times to obtain an active layer with greatly reduced vacancy defect density. The steps of, and novel device for, realizing this method is disclosed herein.

According to yet another aspect of the present disclosure, an arrangement for a reactor for forming a semiconductor device is disclosed. The reactor arrangement is capable of providing an environment for semiconductor device growth with a relatively high group-V precursor partial pressure providing a relatively high population of group-V atoms for incorporation into the growth surface. According to one embodiment, the group-V element is nitrogen and the precursor is $NH_3$.

This aspect may be embodied by a reactor in which the nitrogen precursor is introduced into the growth chamber through a pathway imparting energy to the precursor. The energy may be in the form of heat, which is imparted to the precursor by passing that precursor through a heated channel or channels in the pathway to the reactor chamber. Alternatively, the precursor may be exposed to a catalytic metal such that the precursor is catalytically cracked prior to introduction to the growth surface, thereby presenting elemental nitrogen for incorporation into the growth structure.

In a further embodiment the reactor further comprises an RF induction heater disposed proximate said first injection port for heating said at least one channel as the precursor gas flows therethrough in order to reduce the energy necessary to produce reactive nitrogen therefrom and provide said reactive nitrogen at a relative high chemical potential for incorporation into the growth surface of said growth substrate.

In a further embodiment said at least one channel comprises a catalytic metal surface over which said precursor gas flows as it flows through said at least one channel in order to reduce the energy necessary to produce reactive nitrogen therefrom and provide said reactive nitrogen at a relative high chemical potential for incorporation into the growth surface of said growth substrate.

In a further embodiment the reactor further comprises a matrix of high-surface-area inert material disposed within said at least one channel, such that said precursor gas may flow thereover in order to reduce the energy necessary to produce reactive nitrogen therefrom and provide said reactive nitrogen at a relative high chemical potential for incorporation into the growth surface of said growth substrate.

In a further embodiment said apparatus comprises at least one mesh element disposed within said first injection port and through which said precursor gas flows as it enters the growth chamber, said mesh element heatable as the precursor gas flows therethrough in order to reduce the energy necessary to produce reactive nitrogen therefrom and provide said reactive nitrogen at a relative high chemical potential for incorporation into the growth surface of said growth substrate.

In a further embodiment said mesh element comprises a catalytic metal surface over which said precursor gas flows in order to reduce the energy necessary to produce reactive nitrogen therefrom and provide said reactive nitrogen at a relative high chemical potential for incorporation into the growth surface of said growth substrate.

In a further embodiment the reactor further comprises a matrix of high-surface-area inert material disposed proximate said mesh element, such that said precursor gas may flow thereover in order to reduce the energy necessary to produce reactive nitrogen therefrom and provide said reactive nitrogen at a relative high chemical potential for incorporation into the growth surface of said growth substrate.

In a further embodiment the reactor further comprises a heater disposed proximate said first injection port for heating said matrix of high-surface-area inert material in order to reduce the energy necessary to produce reactive nitrogen therefrom and provide said reactive nitrogen at a relative high chemical potential for incorporation into the growth surface of said growth substrate.

Finally, according to other variations, combinations of the above methods and apparatus may be employed to provide a low vacancy-defect nitride semiconductor structure. The structure is produced in the presence of a high precursor partial pressure in order that the nitrogen vacancy defects are reduced as compared to known methods for producing nitride-based semiconductor devices.

The above is a summary of a number of the unique aspects, features, and advantages of the present invention. However, this summary is not exhaustive. Thus, these and other aspects, features, and advantages of the present invention will become more apparent from the following detailed description and the appended drawings, when considered in light of the claims provided herein.

**BRIEF DESCRIPTION OF THE DRAWINGS**

In the drawings appended hereto like reference numerals denote like elements between the various drawings. While illustrative, the drawings are not drawn to scale. In the drawings:

Figs. 1A and 1B are a plots of the photoluminescence efficiency of arsenide (InGaAs-GaAs quantum wells) and phosphide (bulk InGaP) semiconductors, respectively, as a function of the group-V to group-III molar ratio (V:III ratio) employed during epitaxial growth according to the prior art.

Fig. 2A is a representation of the interaction between the hot, growing crystal surface and the gaseous growth ambient.

Fig. 2B is an energy band diagram illustrating the midgap nonradiative transition associated with the group-V vacancy for the interaction illustrated in Fig. 2A.

Fig. 3 is a re-plotting of the data from Fig. 1A and Fig. 1B as function of group-V partial pressure (rather than V:III ratio as for Figs. 1A and 1B).

Fig. 4 is an illustration of the internal quantum efficiency (IQE) versus drive current density for a "blue" LED with a very high IQE according to the prior art.

Figs. 5A and 5B are graphs of reactor growth pressure used for deposition of AlGaInN multiple-QW laser diodes versus threshold current density (Fig. 5A) and versus Etch pit density (Fig. 5B) for near-UV, 405 nm laser diodes, showing that higher total growth pressure leads to lower threshold laser diodes and lower pit-defect density.

Fig. 6 is a graph showing the equilibrium vapor pressures of nitrogen over surfaces of binary nitride semiconductors AlN, GaN, InN.

Fig. 7 is a graph of the nitride characteristic curve (partial pressure versus luminescence efficiency) showing a displacement toward a higher $NH_3$ partial pressure requirement.

Fig. 8 is a schematic representation of an MOCVD (metal organic chemical vapor deposition) reactor with elements for providing a high nitrogen chemical potential growth environment, representing several embodiments of the present invention.

Fig. 9 is an illustration of the injection port (typically a quartz tube) of an MOCVD reactor which is packed with a high-surface-area, inert material according to an embodiment of the present invention.

Fig. 10 is another schematic representation of an MOCVD (metal organic chemical vapor deposition) reactor with elements for providing a high nitrogen chemical potential growth environment, in this case representing several alternate embodiments of the present invention.

Fig. 11 is a block diagram of the basic steps for forming a nitride film semiconductor device according to one embodiment the present disclosure.

Fig. 12 is a block diagram of the basic steps for forming a nitride film semiconductor device according to an embodiment the present disclosure in which the active region of the device is formed from a plurality of discrete layers.

Fig. 13 is a plot of the calculated chemical potential of nitrogen as a function of the partial pressure of NH3. The five different sets of data correspond to five different values of the partial pressure of H2.

Fig. 14 is a plot of the nitrogen chemical potential as a function of the ratio of the $H_2$ to $NH_3$ partial pressures for a fixed reactor pressure of 760 torr.

**DETAILED DESCRIPTION OF THE INVENTION**

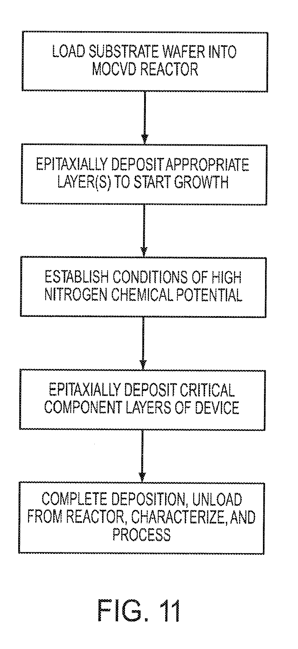

Following we describe several methods for preparing epitaxial nitride semiconductor films, heterostructures, and devices under conditions of high nitrogen chemical potential. These methods include growth with a combination of high total pressure and high nitrogen precursor (e.g., high partial pressure $NH_3$), predisociating the precursor gas, for example by precracking using a catalytic metal surface, prepyrolyzing, using catalytically-cracked molecular nitrogen as a nitrogen precursor, or exposing the surface to an ambient which is extremely rich in active nitrogen species. In general, the following description follows the method illustrated in Fig. 11, although the overall process of forming a nitride semiconductor device is not further discussed herein. However, unless otherwise specified, it will be appreciated that the various steps and methods described herein fit with the general overview of such a process provided by Fig. 11. Furthermore, $NH_3$ (ammonia) is generally referred to as the nitrogen precursor in various embodiments of the present invention, while it will be appreciated that other nitrogen precursors may be substituted or introduced together with $NH_3$ without materially departing from the spirit and scope of the present disclosure.

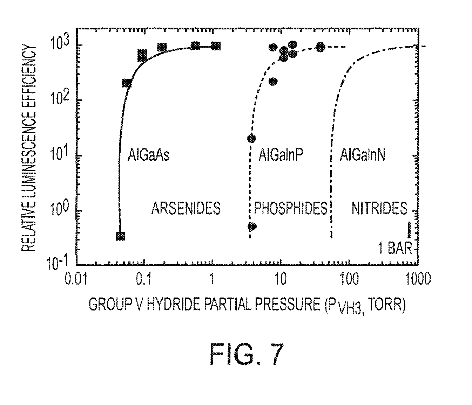

We begin with the realization that high $NH_3$ partial pressure minimizes the tendency for nitrogen vacancy formation (assuming that the nitrogen vacancy is nonradiative, by analogy with arsine and phosphine vacancies). This leads us to the nitride characteristic curve shown in Fig. 7, which is displaced toward a higher $NH_3$ partial pressure requirement, due to the strong character of the ammonia molecule bonds, which make it a difficult molecule to pyrolyze. It should be understood that the characteristic curve in Fig. 7 for AlGaInN is an estimated position and shape, based in part on data extrapolation from the characteristic curves for the arsenide and phosphide. The nitride growth conditions for AlGaInN shown in Fig. 7 are challenging, and pressure and ammonia flow are not necessarily independent variables. Specifically total pressure and/or ammonia flow changes impact other behavior such as growth rate, gas-phase chemistry, turbulence, upstream heating of the ammonia, etc. Nevertheless, it is not unreasonable to conclude that the IQE vs. $P_{NH3}$ characteristic implies a requirement for an ammonia partial pressure ($P_{NH3}$) of several hundred Torr for forming high-efficiency material (as indicated by Fig. 7). This optimum growth condition may be achieved in a simple manner for an MOCVD reactor capable of atmospheric- or super-atmospheric-pressure operation. However, such a condition is difficult or impossible in commercial large volume MOCVD reactors. While these systems are functionally capable of operating at atmospheric pressure, doing so requires high dilution of the ammonia, to avoid convection and gas-phase reactions, and to facilitate transient-free gas switching as required for heterostructure formation. Therefore, we have developed the following as methods and apparatus for obtaining high nitrogen chemical potential growth conditions to provide improved devices and work around the limitations of existing reactors and methods for producing such devices.

The term nitrogen chemical potential used here shall be understood as follows. For the purpose of estimating the nitrogen chemical potential let us approximate the MOCVD environment as a gas containing $NH_3$ and $H_2$ molecules. This is reasonable because the number of $NH_3$ molecules introduced into the reactor is an order of magnitude larger than any other molecule that is introduced. Thus the two most numerous atoms in the gas are N and H.

Consider a system in which ammonia molecules and hydrogen molecules are present in an enclosed volume and reach equilibrium at a temperature T. We will assume that the equilibrium corresponds to a partial pressure Pa for the $NH_3$ and Ph for $H_2$ molecules. The chemical potentials of the N ($\mu_N$) and H ($\mu_H$) are then determined by two equations:

$$[1] \qquad 2\mu_H = E(H_2) + f_H(Ph, T)$$

$$[2] \qquad \mu_N + 3\mu_H = E(NH_3) + f_{NH3}(Pa, T)$$

One may calculate the right hand sides of equations [1] and [2]. See Northrup, Di Felice, and Neugebauer, Phys. Rev. B 56, 4325 (1997). E(M) is the total energy of a molecule M at T=0. The functions $f_H$ and $f_{NH3}$ include the contributions to the free energy coming from translational motion, vibrational motion, and rotations of the molecules.

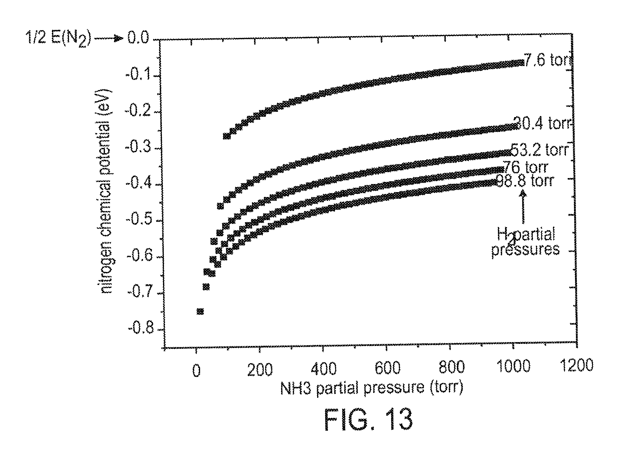

We can solve equations [1] and [2] for $\mu_N$ and plot the result, as illustrated in Fig. 13. The nitrogen chemical potential depends on the partial pressure of $NH_3$, the partial pressure of $H_2$, and the temperature. Results are shown in Fig. 13 for T=970 K, and five different values for partial pressures of hydrogen are considered, varying between 7.6 torr and 98.8 torr. We define "High Nitrogen Chemical Potential" to be $\mu_N - \frac{1}{2}E(N_2) > \sim 1/2\,\Delta H$, where $\Delta H$ is the enthalpy of formation of GaN. ($\Delta H \sim -0.9$ eV.) For example, the condition that $\mu_N - \frac{1}{2}E(N_2) > -0.45$ eV can be met if the partial pressure of $NH_3$ is greater than about 400 torr and the partial pressure of $H_2$ is less than 76 torr. Higher $NH_3$ partial pressures give higher nitrogen chemical potentials. In addition, reduced $H_2$ partial pres-

sures gives rise to higher nitrogen chemical potential.

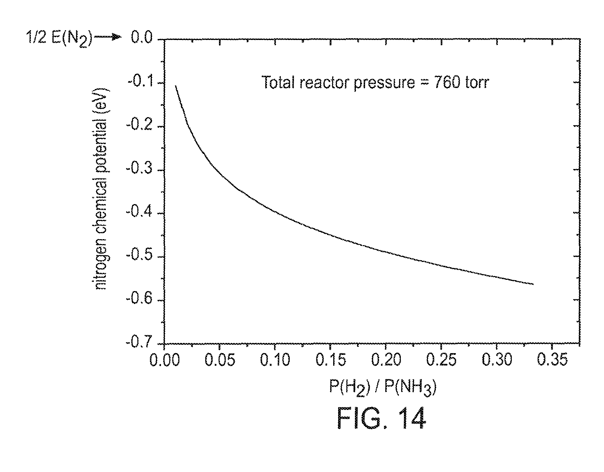

We may also consider the case where the total reactor pressure is fixed at one atmosphere, 760 torr, and plot the nitrogen chemical potential as a function of the ratio of the $H_2$ to $NH_3$ partial pressures. This is illustrated in Fig. 14. It can be seen that the ratio $P(H_2)/P(NH_3)$ should be less than 0.15 to achieve what we define as High Nitrogen Chemical Potential.

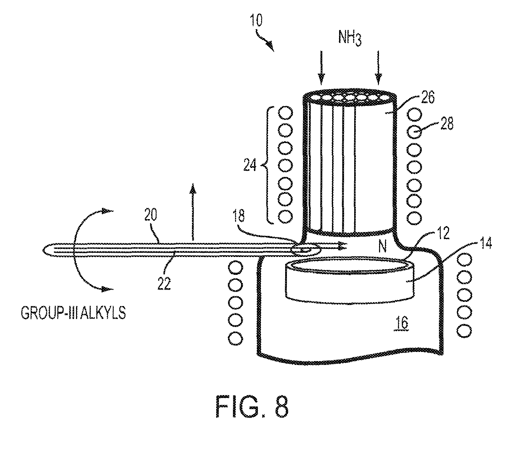

With reference to Fig. 8, there is shown therein a schematic representation of an MOCVD (metal organic chemical vapor deposition) reactor 10 with elements for providing a high nitrogen chemical potential growth environment. A growth substrate 12 is placed on a platen 14 in a growth chamber 16 of reactor 10. A precursor gas input is provided above platen 14 such that gas introduced thereby is introduced onto or proximate the surface of substrate 12. In one embodiment, the precursor gas is $NH_3$ (ammonia), introduced so as to flow downward and over substrate 12. The group-III alkyls may be injected vertically, horizontally, or at some angle in-between, through port 18, into chamber 16. The group-III alkyls must be injected at a temperature below their pyrolysis temperature. E.g., the injection temperature may be at or below about 300°C, kept cool by a sheath 20 surrounding a central tube 22 carrying the group-III precursors and surrounded in sheath 20 by an outer flow of cooling gas such as $H_2$, $N_2$, or $NH_3$.

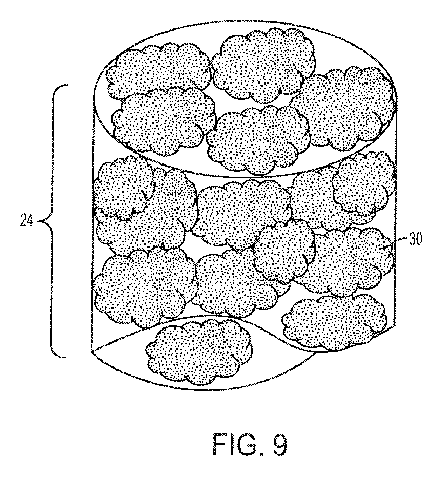

According to one embodiment, the $NH_3$ is pre-pyrolyzed by heating the gas stream upstream of substrate 12. This may be accomplished by passing the $NH_3$ through injection port 24, such as passing it through heated channels 26, constructed, for example, of refractory metals (molybdenum, tantalum, etc.), ceramic (boron-nitride, alumina, etc.), SiC, SiC- coated-graphite, or GaN. Channels 26 may be of virtually any cross sectional shape, such as round, oval, rectangular, hexagonal, etc. Depending on their construction, channels 26 may be heated via RF induction (with coils 28 as shown), with a resistance heated furnace (not shown) surrounding injection port 24 and/or channels 26, or other method and device. Alternatively, the upstream section of the injection port 24 (typically a quartz tube) may be heated and packed with a matrix of high-surface-area, inert material 30 such as metal wool, quartz balls, etc., shown in Fig. 9, that can transfer their heat to the ammonia. Many variations of the embodiment described above are possible, such as, a combination of channels 26 that are heated by rf induction ("hot" tubes) interspersed with other channels (not shown) that remain cooler (e.g., quartz tubes), and channels that carry different combinations of gases (e.g., some with $NH_3$ and others with $H_2$ or $NH_3/H_2$).

According to another embodiment of the present invention, prior to introduction into growth chamber 16, the precursor (ammonia) is cracked catalytically on an appropriate metal surface. For example, channels 26 may be fabricated from a known catalytic metal such as nickel, palladium, platinum, ruthenium, etc., and used to crack the precursor upstream of the wafer. These metal surfaces may be heated, for example by RF coils 28, to further enhance dissociation of the nitrogen from the precursor. These simultaneous actions of catalysis and heating encourages dissociation of the nitrogen from the precursor, aiding in the formation of a film in the presence of high nitrogen chemical potential. Furthermore, the hot gas minimizes convection-driven turbulence in the reactor.

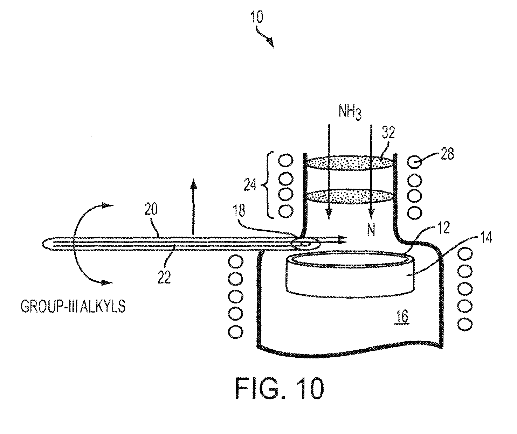

In a variation of the above embodiment illustrated in Fig. 10, a "showerhead", screen, porous frit or similar mesh element 32 fabricated from the appropriate catalytic metal replaces channels 26. Element 32 may be directly heated, or alternatively heating of the catalytic surface may not be necessary. Again, an inert material 30 such as metal wool, quartz balls, etc. (Fig. 9) may be located within injection port 24, before, after or between two such elements 32.

In the embodiments above it is important to take measures to prevent the active nitrogen species from recombining prior to reaching the growth substrate 12. If such measures are not taken, molecular nitrogen, $N_2$, is presented to growth substrate 12, as opposed to reactive forms of nitrogen including $NH_3$, $NH_2$, NH, N, as well as others. Molecular nitrogen will not effectively be incorporated in the growth film in the manner of reactive forms of nitrogen, and consequently will not effectively lower the nitrogen vacancies in the growth film. Measures to ensure that reactive forms of nitrogen, as opposed to molecular nitrogen is imparted onto the growth surface of growth substrate 12 include: performing the pre-pyrolization relatively very close to growth substrate 12, with a gas flow vector directing the pre-pyrolized precursor directly onto the growth surface. Gas flow rate of the precursor must also be selected such that it is given sufficient time on channels 26 or element 32 to be pyrolized but then move rapidly to the surface of growth substrate 12. In addition, the various temperatures within the chamber 16 and injection part 24 must be controlled such that the energy imparted to the precursor is not lost, and nitrogen recombination occurs, prior to its incidence upon the surface of growth substrate 12.

In yet another embodiment of the present invention, molecular nitrogen may be introduced into growth chamber 16 directly. Such an introduction of molecular nitrogen would supplement rather than replace the introduction of $NH_3$ and would further increase the chemical potential of nitrogen (without also increasing the chemical potential of hydrogen). This introduction would be most effective if a catalyst, such as ruthenium, were present. However, in this case steps must be taken to break apart the molecular nitrogen, similar to the methods for breaking apart $NH_3$ (however at a higher energy than $NH_3$ due to the higher molecular bond energy of $N_2$). Here again, the choice of metal surface is key to efficiently activating the selected nitrogen precursor.

According to still another embodiment of the present invention, the pre-pyrolysis or catalytic pre-cracking described above are employed on a primary nitrogen precursor (e.g., $NH_3$) to form in-situ a secondary nitrogen precursor that is more easily activated than the primary precursor. For example, hydrazine, hydrazine variants, hydrogen azide, etc. may be generated; and these species are more chemically active than ammonia.

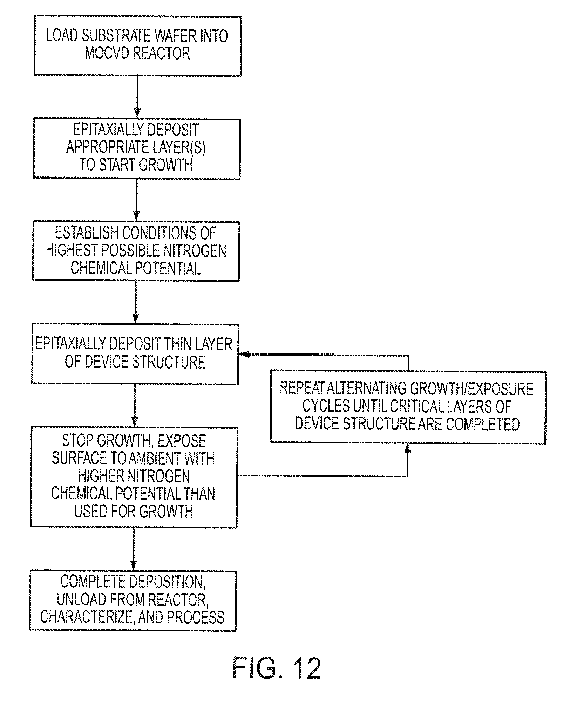

According to a still further embodiment of the present invention, the growth may proceed by alternating steps which include growth and high-active nitrogen exposure. One example of this approach is a two-step process including conventional growth of very thin (e.g., one- to several-atoms thick) layers, followed by brief exposure to an ambient with an extraordinarily high partial pressure of active nitrogen, as illustrated in Fig. 12. According to this embodiment, this sequence is repeated until the desired thickness is reached. During the conventional growth component of the sequence, the normal growth chemistry is employed (e.g., TMGa + $NH_3$), thereby ensuring the proper elimination of carbon. During the high-active-nitrogen exposure, any nitrogen vacancies formed on the surface would become filled by the abundance of available nitrogen. In this manner, materials with lower nitrogen vacancy concentration might be produced.

It should now be appreciated that an improved class of nitride materials is enabled by the present invention, particularly high-indium-content alloys that are used for green light-emitting devices. These materials are characterized by a low nitrogen vacancy concentration. The method by which these materials are deposited includes the condition of high nitrogen chemical potential. As stated above, this could include high ammonia (or other appropriate precursor) partial pressure, precracking of ammonia using a catalytic metal surface, prepyrolyzing ammonia, using catalytically-cracked molecular nitrogen as a nitrogen precursor, or exposing the surface to an ambient which is extremely rich in reactive nitrogen species.

The physics of modern electrical devices and the methods of their production are not absolutes, but rather statistical efforts to produce a desired device and/or result. Even with the utmost of attention being paid to repeatability of processes, the cleanliness of manufacturing facilities, the purity of starting and processing materials, and so forth, variations and imperfections result. Accordingly, no limitation in the description of the present invention or its claims can or should be read as absolute. The limitations of the claims are intended to define the boundaries of the present invention, up to and including those limitations. To further highlight this, the term "substantially" may occasionally be used herein in association with a claim limitation (although consideration for variations and imperfections is not restricted to only those limitations used with that term). While as difficult to precisely define as the limitations of the present invention themselves, we intend that this term be interpreted as "to a large extent", "as nearly as practicable", "within technical limitations", and the like.

**Claims**

1. A method of producing an epitaxial nitride film for a semiconductor device in a growth environment, comprising:

    locating within a reactor growth chamber a growth substrate;
    producing a High Nitrogen Chemical Potential environment comprising the steps of;
    injecting a precursor gas into said growth chamber in a direction such that said precursor gas is introduced at least proximate a growth surface of said growth substrate, said precursor gas being a nitrogen source;
    injecting group-III alkyls into said growth chamber, said group-III alkyls injected at a temperature below their pyrolysis temperature; and
    growing an epitaxial nitride film in said growth environment;
    whereby a nitride semiconductor film is grown having an improved device performance.

2. The method of claim 1, wherein said High Nitrogen Chemical Potential, $\mu_N$, is such that $\mu N - \frac{1}{2} E(N_2)$ is greater than at least $1/2 \Delta H$, where $\Delta H$ is the enthalpy of formation of GaN.

3. The method of claim 2, wherein $\mu N - \frac{1}{2} E(N_2)$ is greater than - 0.45 eV.

4. The method of claim 3 wherein said growth environment includes a partial pressure of $NH_3$ greater than 400 torr and a partial pressure of $H_2$ less than 76 torr.

5. A method of producing an epitaxial nitride film for a semiconductor device, comprising:

    locating within a reactor growth chamber a growth substrate;
    predissociating a precursor gas such that said predissociated precursor gas has an increased capability of providing relatively high nitrogen chemical potential as compared to the precursor gas which has not been predissociated;
    injecting said predissociated precursor gas into said growth chamber in a direction such that said precursor gas is introduced at least proximate a growth surface of said growth substrate; and
    injecting group-III alkyls into said growth chamber, said group-III alkyls injected at a temperature below their pyrolysis temperature;
    whereby a nitride semiconductor film is grown having an improved device performance.

6. The method of claim 5 wherein said relatively high nitrogen chemical potential comprises providing said precursor gas at least 400 Torr.

**7.** The method of claim 6 wherein said precursor gas and any other gases, including said group-III alkyls, are injected into said growth chamber substantially in equally volumes.

**8.** The method of claim 5, wherein said predissociation comprises elevating the temperature of said precursor gas prior to injection into said growth chamber in order to pre-pyrolize the precursor gas and reduce the energy necessary to produce reactive nitrogen therefrom and provide said reactive nitrogen at a relative high chemical potential for incorporation into the growth surface of said growth substrate.

**9.** The method of claim 8, wherein said elevating of the gas temperature is accomplished by injecting said precursor gas through at least one heated channel in order to reduce the energy necessary to produce reactive nitrogen therefrom and provide said reactive nitrogen at a relative high chemical potential for incorporation into the growth surface of said growth substrate.

**10.** The method of claim 8, wherein said elevating of the gas temperature is accomplished by injecting said precursor gas through a matrix of high-surface-area inert material which is maintained at an elevated temperature in order to reduce the energy necessary to produce reactive nitrogen therefrom and provide said reactive nitrogen at a relative high chemical potential for incorporation into the growth surface of said growth substrate.

**11.** The method of claim 5, wherein said predissociation comprises injecting said precursor gas over a catalytic surface in order to reduce the energy necessary to produce reactive nitrogen from said precursor gas and provide said reactive nitrogen at a relative high chemical potential for incorporation into the growth surface of said growth substrate.

**12.** A method of producing an epitaxial nitride film for a semiconductor device, comprising;

performing in a growth chamber a metal organic chemical vapor deposition of constituent species onto a growth surface to grow a layer of semiconductor film thereon;
interrupting said metal organic chemical vapor deposition prior to its completion;
exposing said growth surface to a high nitrogen chemical potential ambient;
reducing the nitrogen chemical potential of the growth chamber; and
resuming said metal organic chemical vapor deposition growth of said semiconductor film.

**13.** A method of producing an epitaxial nitride film for a semiconductor device, comprising:

locating within a reactor growth chamber a growth substrate;
performing a first metal organic chemical vapor deposition of constituent species to form a first layer of semiconductor film on said growth substrate;
injecting a precursor gas into said growth chamber such that the pressure within said chamber is elevated to above at least 1 atmosphere, said precursor gas being injected in a direction such that it is introduced at least proximate a growth surface of said first layer of semiconductor film, said precursor gas being a nitrogen source such that reactive nitrogen may thereby be provided at a relative high chemical potential and nitrogen may be incorporated therefrom into said growth surface of said first layer of semiconductor film;
reducing the pressure in said growth chamber;
performing a second metal organic chemical vapor deposition of constituent species to form a second layer of semiconductor film on said first layer of semiconductor film; and
injecting said precursor gas into said growth chamber such that the pressure within said chamber is again elevated to at least 1 atmosphere, said precursor gas being injected in a direction such that it is introduced at least proximate a growth surface of said second layer of semiconductor film, said precursor gas being a nitrogen source such that reactive nitrogen may thereby be provided at a relative high chemical potential and nitrogen may be incorporated therefrom into said growth surface of said second layer of semiconductor film;
whereby a layered nitride semiconductor film is grown yielding improved device performance.

**14.** A chemical deposition reactor for the production of an epitaxial nitride film for a semiconductor device comprising:

an enclosure defining a growth chamber;
a substrate carrier located with said chamber;
a first injection port for injecting a precursor gas into said growth chamber, said first injection port disposed in said enclosure and positioned such that a precursor flowing therethrough is injected in a direction into said growth chamber generally onto a surface of said substrate carrier;
a second injection port for injecting a group-III alkyls into said growth chamber, said second injection port disposed in said enclosure and positioned such that a group-III alkyls flowing therethrough into said growth chamber are introduced in a direction which is non-parallel to the direction of introduction of said precursor gas; and
an apparatus associated with said first injection port for providing reactive nitrogen in said growth chamber at a relatively high chemical potential for incorporation into a growth surface of a growth substrate located on said substrate carrier.

15. The reactor of claim 14, wherein said apparatus comprises at least one channel disposed within said first injection port, said channel heatable as the precursor gas flows therethrough in order to reduce the energy necessary to produce reactive nitrogen therefrom and provide said reactive nitrogen at a relative high chemical potential for incorporation into the growth surface of said growth substrate.

FIG. 1A
PRIOR ART

FIG. 1B
PRIOR ART

FIG. 2A
PRIOR ART

FIG. 2B
PRIOR ART

FIG. 3
PRIOR ART

FIG. 4
PRIOR ART

FIG. 5A
PRIOR ART

FIG. 5B
PRIOR ART

**TEMPERATURE T [°C]**

FIG. 6
PRIOR ART

FIG. 7

FIG. 8

FIG. 9

FIG. 10

```
┌─────────────────────────────────┐
│    LOAD SUBSTRATE WAFER INTO    │
│         MOCVD REACTOR           │
└─────────────────────────────────┘
                │
                ▼
┌─────────────────────────────────┐
│  EPITAXIALLY DEPOSIT APPROPRIATE│
│    LAYER(S) TO START GROWTH     │
└─────────────────────────────────┘
                │
                ▼
┌─────────────────────────────────┐
│    ESTABLISH CONDITIONS OF HIGH │
│   NITROGEN CHEMICAL POTENTIAL   │
└─────────────────────────────────┘
                │
                ▼
┌─────────────────────────────────┐
│     EPITAXIALLY DEPOSIT CRITICAL│
│    COMPONENT LAYERS OF DEVICE   │
└─────────────────────────────────┘
                │
                ▼
┌─────────────────────────────────┐
│   COMPLETE DEPOSITION, UNLOAD   │
│  FROM REACTOR, CHARACTERIZE, AND│
│            PROCESS              │
└─────────────────────────────────┘
```

FIG. 11

LOAD SUBSTRATE WAFER INTO
MOCVD REACTOR

↓

EPITAXIALLY DEPOSIT
APPROPRIATE LAYER(S)
TO START GROWTH

↓

ESTABLISH CONDITIONS OF
HIGHEST POSSIBLE NITROGEN
CHEMICAL POTENTIAL

↓

EPITAXIALLY DEPOSIT THIN LAYER
OF DEVICE STRUCTURE

REPEAT ALTERNATING GROWTH/EXPOSURE
CYCLES UNTIL CRITICAL LAYERS OF
DEVICE STRUCTURE ARE COMPLETED

↓

STOP GROWTH, EXPOSE
SURFACE TO AMBIENT WITH
HIGHER NITROGEN
CHEMICAL POTENTIAL THAN
USED FOR GROWTH

↓

COMPLETE DEPOSITION,
UNLOAD FROM REACTOR,
CHARACTERIZE, AND PROCESS

FIG. 12

FIG. 13

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Northrup ; Di Felice ; Neugebauer.** *Phys. Rev. B,* 1997, vol. 56, 4325